(19) Europäisches Patentamt

European Patent Office

Office européen des brevets

(11) Veröffentlichungsnummer: **0 499 116 A1**

# EUROPÄISCHE PATENTANMELDUNG

(12)

(21) Anmeldenummer: **92101767.9**

(51) Int. Cl.⁵: **H03F 1/52**, H03F 3/24, H05K 7/20

(22) Anmeldetag: **04.02.92**

(30) Priorität: **11.02.91 DE 4104064**
**13.09.91 US 759229**

(43) Veröffentlichungstag der Anmeldung:
**19.08.92 Patentblatt 92/34**

(84) Benannte Vertragsstaaten:
**CH DE ES FR GB IT LI**

(71) Anmelder: **ELAN Elektronische Anlagen GmbH**
**Hauptstrasse 57**
**W-6087 Büttelborn 2(DE)**

(72) Erfinder: **Roskewitsch, Janusz, Dr. Ing.**
**Evlenweg 13**
**W-6551 Wallertheim(DE)**
Erfinder: **Hüttl, Matthias**
**Wilhelm Leuschner Strasse 39**
**W-6087 Büttelborn 2(DE)**

(74) Vertreter: **Patentanwälte Dipl.-Ing. F.W. Möll**
**Dipl.-Ing. H.Ch. Bitterich**
**Langstrasse 5 Postfach 2080**
**W-6740 Landau/Pfalz(DE)**

(54) **Kompaktes RF-Leistungsgenerator-System.**

⑤ Die Erfindung betrifft ein RF-Leistungsgenerator-System für den Frequenzbereich von 2 bis 30 MHz und einer programmierbaren Sinus-Ausgangsleistung von 0 bis 1000 W. Das System ist aufgebaut aus Modulen (10, 30, 50, 70, 90), die in ein flaches, quaderförmiges Gehäuse (1) mit einem Volumen von 4,6 Liter eingebaut sind. Das Gehäuse (1) besteht im wesentlichen aus zwei seitlichen Profilen (4), einem Frontblech (6), einem Bodenblech (5) und einem (nicht dargestellten) Gehäusedeckel. Ein Kristall-gesteuertes Leistungssendermodul (10) ist mittels RF-Leitung (121) mit einem Zwischenverstärkermodul (30), dieses über eine RF-Leitung (122) mit einem Leistungsendverstärkermodul (50), dieses über eine RF-Leitung (123) mit einem Hochleistungsfilter (70) und dieses über eine RF-Leitung (124) mit einem Hochleistungsrichtkoppler (90) verbunden. An einem RF-Stecker (2) kann die RF-Ausgangsleistung abgenommen werden.

Ein flacher Ventilator (120) erzeugt die Kühlluft für die Leistungsmodule (30, 50, 70, 90). Module (10, 30, 50, 90) mit eingebauter Elektronik besitzen jeweils eine integrierte Steuer- und Diagnoseeinheit, die über Mehrfachkabel (125, 126, 127, 128) mit einer Logikeinheit (110) in Verbindung steht. Meßwerte werden an einem Display (111) angezeigt. An Einstellern (112) können bestimmte Betriebsarten vorgewählt werden.

EP 0 499 116 A1

Fig. 19

Die Erfindung betrifft das Gebiet der RF-Leistungsgeneratoren. RF bedeutet Radio-Frequenz im Bereich zwischen etwa 2 und 30 MHz. Die Ausgangsleistung beträgt typisch 1 kW an einem Belastungswiderstand von 50 Ohm. Solche RF-Generator-Systeme werden benötigt in Kathodenzerstäubungsanlagen, in Gasplasmaanlagen, in medizinischen Geräten, in Anlagen der Telekommunikation usw.

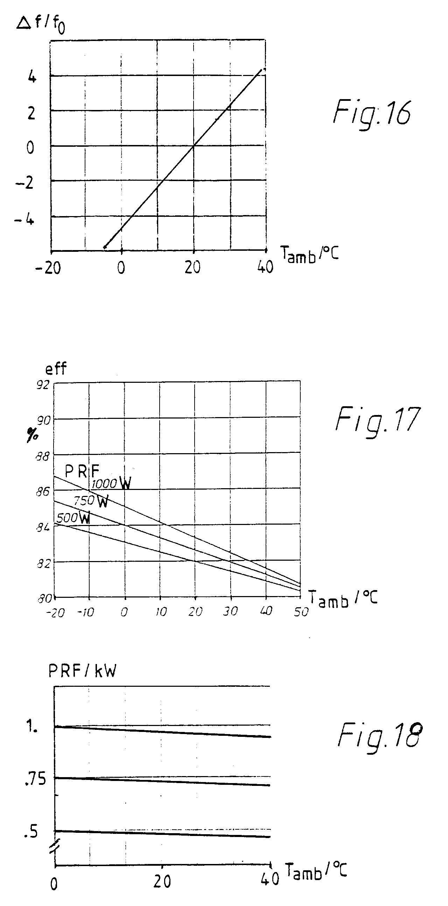

Herkömmliche RF-Generatoren in diesen Leistungs- und Frequenzbereichen sind sehr voluminös (IEEE Transactions on Broadcasting, Vol. BC-26, No. 14, Dec. 1980, Seite 99 - 112, Fig. 18). Der hohe Raumbedarf ist auf verschiedene Ursachen zurückzuführen. Zum einen arbeiten die verstärkenden Bauelemente, beispielsweise Transistoren, bei hohen Frequenzen mit relativ großen Verlusten; die entstehende Wärme muß mit großen Kühlkörpern abgeführt werden. Um hohe Gütewerte zu erzielen, werden die magnetischen Bauelemente, insbesondere die RF-Spulen und -Transformatoren, überwiegend als Luftspulen ausgebildet; dadurch werden diese Bauelemente ebenfalls sehr voluminös. Um elektromagnetische Interferenzen zu verhindern, müssen alle Bauelemente in ein Abschirmgehäuse eingesetzt werden. Um negative Auswirkungen insbesondere auf die Parameter der magnetischen Bauelemente zu vermeiden, muß das Abschirmgehäuse jedoch einen erheblichen Abstand zu den schon voluminösen magnetischen Bauteilen einhalten. Diese und weitere übliche Konstruktionsprinzipien führen schließlich zu der erheblichen Baugröße derartiger Generatoren.

Aufgabe der vorliegenden Erfindung ist es, ein RF-Leistungsgenerator-System mit einem sehr kompakten, vorzugsweise extrem flachen Aufbau anzugeben, der speziell als Einschub in Schaltschränken geeignet ist. Diesbezüglich war eine ganze Reihe neuartiger Konstruktionsprinzipien zu entwickeln.

Aufgabe der Erfindung ist desweiteren, die Baugröße jeder einzelnen elektronischen Funktionseinheit des Generator-Systems auf ein Minimum zu verringern, d. h. die RF-Leistungsdichte, gemessen in RF-Leistung pro Volumen, auf ein Maximum zu erhöhen, ohne daß dabei irgendwelche Abstriche bezüglich Wirkungsgrad, Zuverlässigkeit, Ausfallrate (MTBF), Einsatzmöglichkeit usw. gemacht werden müssen. Hierzu mußten teilweise neuartige Schaltungsprinzipien entwickelt, mit an sich bekannten Schaltungsprinzipien kombiniert und schließlich in geeigneter Form realisiert werden.

Aufgabe der Erfindung ist desweiteren, die einwandfreie Funktion der elektronischen Schaltungskomponenten durch integrierte Überwachungsschaltungen abzusichern, wobei diese Überwachungsschaltungen so schnell ansprechen müssen, daß Schäden an den elektronischen Schaltungselementen, insbesondere Transistoren, durch Übertemperaturen bzw. Überströme mit Sicherheit verhindert werden.

Aufgabe der vorliegenden Erfindung ist weiterhin, die elektronischen Schaltungseinheiten so auszurüsten, daß sie von außen durch Input-Steuersignale gesteuert werden können. Steuern bedeutet beispielsweise: Einstellen einer gewünschten RF-Ausgangsleistung, Modulieren der RF-Ausgangsleistung, Ab- und Anschalten der RF-Ausgangsleistung usw.

Aufgabe der Erfindung ist weiterhin, eine Logikeinheit anzugeben, die externe Steuersignale des Benutzers mit den Ausgangssignalen der einzelnen Elektronikeinheiten verknüpft, den Zustand des Generatorsystems anzeigt und gleichzeitig die erforderlichen Steuersignale zur gewünschten Beeinflussung der Elektronikeinheiten des RF-Generator-Systems erzeugt.

Aufgabe der vorliegenden Erfindung ist weiterhin sicherzustellen, daß die in jeder Elektronikeinheit eingebauten Steuer- und Überwachungsschaltungen durch die um den Faktor $10^3$ bis $10^7$ höheren RF-Leistungen nicht gestört werden.

Aufgabe der Erfindung ist es schließlich, die unvermeidlichen Einflüsse der Umgebungsbedingungen, insbesondere der Umgebungstemperatur, auf den Generator, insbesondere die Generatorausgangsleistung, durch geeignete Regelschaltungen zu minimieren, ohne daß das Generator-System überlastet wird oder gar ausfällt.

Diese Aufgabe wird gelöst durch ein gattungsgemäßes Generator-System mit den Merkmalen des Anspruchs 1, mit vorteilhaften Weiterbildungen und Ausgestaltungen gemäß den Unteransprüchen.

Die erfindungsgemäße Lösung der vorstehend aufgezählten Aufgaben läßt sich am besten anhand der Zeichnungen und der dort erläuterten Ausführungsbeispiele beschreiben und verstehen. Es zeigen

| | |
|---|---|
| Fig. 1 | ein allgemeines Blockschaltbild eines RF-Leistungsgenerator-Systems, |
| Fig. 2 | ein Blockschaltbild eines RF-Leistungsgenerator-Systems, einschließlich des zu seinem Betrieb erforderlichen Gleichspannungsnetzteils sowie einiger Regel- und Überwachungsschaltungen, |
| Fig. 3 | in schematischer Darstellung ein Elektronikmodul, |
| Fig. 4 | eine Draufsicht auf einen Magnetringkern mit Kühlkörper, |
| Fig. 5 | einen Querschnitt durch ein Elektronikmodul im Bereich ei- |

nes Magnetringkerns mit Kühlkörper,

Fig. 6    eine perspektivische, teilweise aufgebrochene Darstellung eines kompakten RF-Tiefpaßfilters für hohe Leistungen,

Fig. 7    eine perspektivische, teilweise aufgebrochene Darstellung eines kompakten Richtkopplers für hohe Leistungen mit nur einer Einrichtung zum Justieren des Richtverhältnisses,

Fig. 8    ein Schema-Schaltbild eines Kristall-gesteuerten Sender-Leistungs-Moduls mit zusätzlichen Überwachungs- und Steuerschaltkreisen,

Fig. 9 bis 12    verschiedene Ausführungen von Rückkopplungsschaltkreisen mit verteilten Widerständen und Kondensatoren, geeignet zum Einsatz in der Schaltung nach Fig. 8,

Fig. 13    ein Schema-Schaltbild eines RF-Verstärkermoduls mit zusätzlichen Überwachungs- und Steuerschaltkreisen,

Fig. 14    eine RF-Eingangsschaltung, wie sie in der Verstärkerschaltung nach Fig. 13 verwendet werden kann,

Fig. 15    eine Stromüberwachungsschaltung, wie sie in den Schaltungen der Fig. 8 und 13 verwendet werden kann,

Fig. 16    die Frequenzgenauigkeit Delta f/fn des RF-Leistungsgenerator-Systems nach Fig. 2 in Abhängigkeit von der Umgebungstemperatur Tamb,

Fig. 17    die Abhängigkeit des Wirkungsgrades eff des RF-Leistungsgenerator-Systems nach Fig. 2 in Abhängigkeit von der Umgebungstemperatur Tamb bei verschiedenen RF-Ausgangsleistungen PRF,

Fig. 18    die Abhängigkeit der RF-Ausgangsleistung PR des RF-Leistungsgenerator-Systems nach Fig. 2 von der Umgebungstemperatur Tamb, und zwar ohne den Vorwärts-Leistungs-Regler der Fig. 2 und

Fig. 19    eine Draufsicht auf das betriebsbereite RF-Leistungsgenerator-System, aufgebaut aus Modulen und eingebaut in ein Gehäuse.

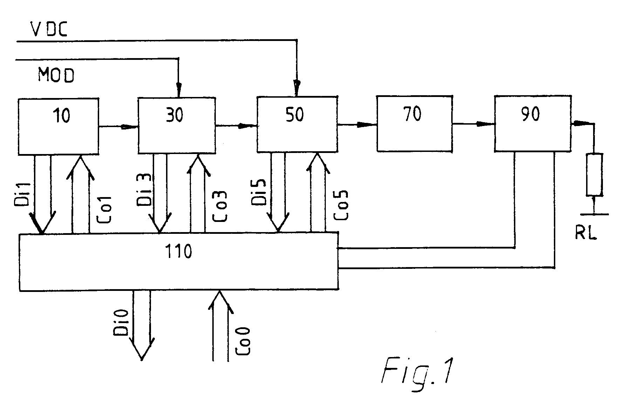

Fig. 1 zeigt einen RF-Leistungsgenerator mit allen für seinen störungsfreien Betrieb erforderlichen Komponenten. Er besteht im wesentlichen aus sechs Einheiten, und zwar einem Leistungssendermodul 10, einem Zwischenverstärkermodul 30, einem Leistungsendverstärkermodul 50, einem Hochleistungstiefpaßfilter 70, einem Hochleistungsrichtkoppler 90 und einer Logikeinheit 110. Der Ausgang ist mit einem Lastwiderstand RL abgeschlossen.

Die Logikeinheit 110 gibt an den Benutzer Diagnosesignale Di0 ab. Der Benutzer beeinflußt die Logikeinheit durch Steuersignale Co0.

Die ersten drei Module 10, 30, 50 sind Elektronikmodule mit integrierten Steuer- und Diagnoseeinheiten. Diganosesignale Di1, Di3, Di5 geben Auskunft über ihre inneren Zustände. Steuersignale Co1, Co3, Co5 ermöglichen gezielte Eingriffe in die Elektronikmodule 10, 30, 50.

Anschlüsse für ein Modulationssignal MOD sowie für eine besonders leistungsfähige Versorgungsgleichspannung VDC vervollständigen das Generatorsystem.

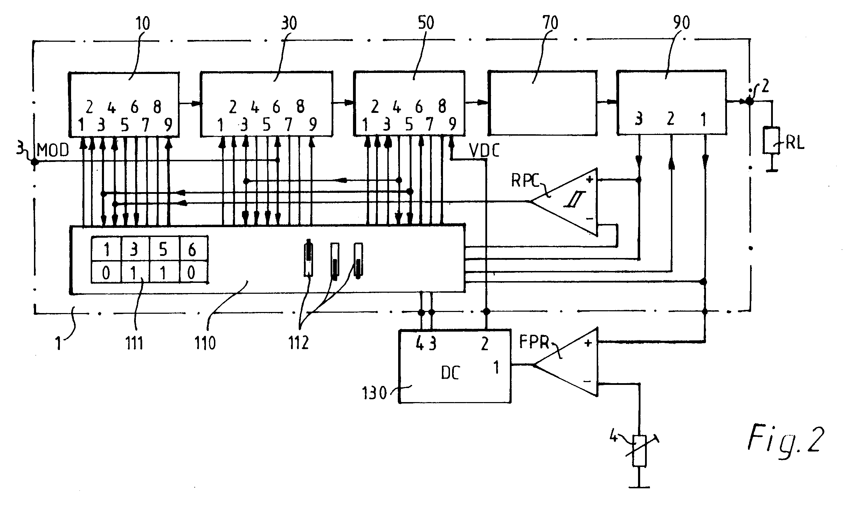

Fig. 2 zeigt eine konkrete Ausführungsform des RF-Leistungsgenerator-Systems der Fig. 1. Das Generator-System 1 ist symbolisiert durch eine strichpunktierte Linie; externe Komponenten komplettieren das System.

Die Elektronikmodule 10, 30, 50 besitzen jeweils neun Anschlüsse pro Modul. Über einen Teil dieser Anschlüsse melden die Module 10, 30, 50 ihre aktuellen Zustände sowie gegebenenfalls aufgetretene Fehler an die Logikeinheit 110. Diese zeigt die Zustände auf einem Display 111 an. Gleichzeitig kann der Benutzer mit Hilfe von Einstellern 112 bestimmte Werte vorgeben, die in der Logikeinheit 110 mit den anderen Signalen verknüpft werden und als Steuersignale den Betrieb der Elektronikmodule 10, 30, 50 beeinflussen.

Fig. 2 zeigt auch ein zum Betrieb des Generators 1 erforderliches Gleichspannungsversorgungsnetzteil 130. Dieses liefert an seinen Ausgängen 130.3, 130.4 Gleichspannungen konstanter Höhe zum Betrieb der Logikschaltungen einerseits und der RF-Module 10, 30 kleiner Leistung andererseits. Am Ausgang 130.2 liegt die Versorgungsgleichspannung VDC einstellbarer Höhe, mit der das Leistungsverstärkermodul 50 direkt gespeist wird. Ein Vorwärtsleistungsregler FPR vergleicht zu diesem Zweck das am Ausgang 90.1 des Richtkopplers 90 anliegende Signal für die RF-Ausgangsleistung PRF mit einem an einem Potentiometer 4 eingestellten Sollwert und liefert das entsprechende Differenzsignal als Regelgröße an den Eingang 130.1 des DC-Netzteils 130.

DC-Netzteile, die Spannungen einstellbarer Höhe abgeben, sowie Regelschaltungen zu deren Betrieb sind handelsüblich. Um den Wirkungsgrad des gesamten Generators möglichst hoch, die Betriebsverluste also möglichst gering zu halten, empfiehlt es sich, das DC-Netzteil 130 als Schaltnetzteil auszubilden.

In Fig. 2 erkennt man weiterhin noch eine Überwachungs- und Schutzschaltung in Form eines als Schmitt-Trigger ausgebildeten Rückwärtsleistungskomparators RPC. Dessen einer Eingang RPC + ist mit dem Rückwärtsleistungsmeßausgang 90.3 des Richtkopplers 90 verbunden. Bei Überschreiten der Schaltschwelle des Triggers gelangt ein Sperrsignal an den Disable-Eingang 10.4 des Sendermoduls 10 und schaltet dieses ab. Auf diese Weise wird der Generator 1 abgeschaltet, wenn am Ausgang 2 eine erhebliche Fehlanpassung gemessen wird, beispielsweise infolge eines Kurzschlusses oder eines Leitungsbruchs.

Am Eingang 3 des Generators 1 schließlich kann das externe Rechteck-Modulationssignal MOD eingegeben werden. Dieses gelangt an den Modulationseingang 30.6 des Zwischenverstärkermoduls 30 und steuert den programmierbaren Verstärkungsfaktor dieses Zwischenverstärkermoduls 30.

Über ein weiteres Steuersignal kann die Form der RF-Ausgangsspannung zwischen Quasi-Sinus - mit Filter - und Quasi-Rechteck - ohne Filter - umgeschaltet werden.

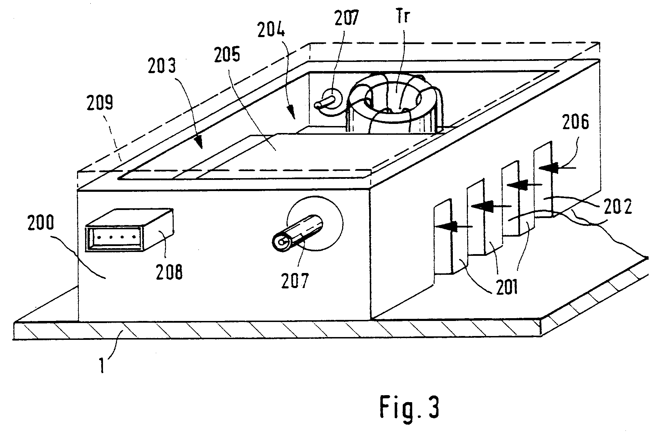

Fig. 3 zeigt in perspektivischer Darstellung den grundsätzlichen Aufbau der Elektronik-Module 10, 30, 50. Wesentliches Element ist ein parallelepipedischer Kühlkörper 200, an dessen Unterseite Kühlrippen 201 angeformt sind. Setzt man wie in der Zeichnung dargestellt die Kühlrippen 201 direkt auf den Boden des Generatorgehäuses 1, so entstehen Kühlkanäle 202 für einen Kühlluftstrom 206.

In der Oberseite des Kühlkörpers 200 erkennt man einen Montageraum 203, 204. Darin befinden sich die elektronischen Bauteile und Komponenten, beispielsweise eine SMD-, Dickfilm-, Dünnfilmund/oder Hybrid-Schaltung auf einer Keramik-Schaltungsplatte 205, die in an sich bekannter Weise Leiterbahnen und Bauteile trägt, sowie sonstige Einzelbauelemente, beispielsweise ein Ringkerntransformator Tr. Nach oben ist der Montageraum 203, 204 durch einen Deckel 209 hochfrequenzdicht verschlossen.

Um die in den Bauelementen auf der Schaltungsplatte 205 oder auch im Ringkern des Transformators Tr entstehende Wärme optimal abführen zu können, muß ein optimaler Kontakt zum Kühlkörper 200 und/oder zum Deckel 206 bestehen. Aus diesem Grund wird die Höhe des Montageraums 203, 204 an die Abmessungen der einzelnen Bauteile angepaßt, gegebenenfalls unter Bildung von einer oder mehreren Stufen. Deshalb ist die Höhe des Teil-Montageraums 203 im Bereich der Schaltungsplatte 205 geringer als die des Teil-Montageraums 204 im Bereich des Ringkerntransformators Tr.

Die Diagnose-Ausgangssignale sowie die Steuersignale liegen an einem Stecker 208 an. Die RF-Signale liegen an RF-Steckverbindungen 207 an.

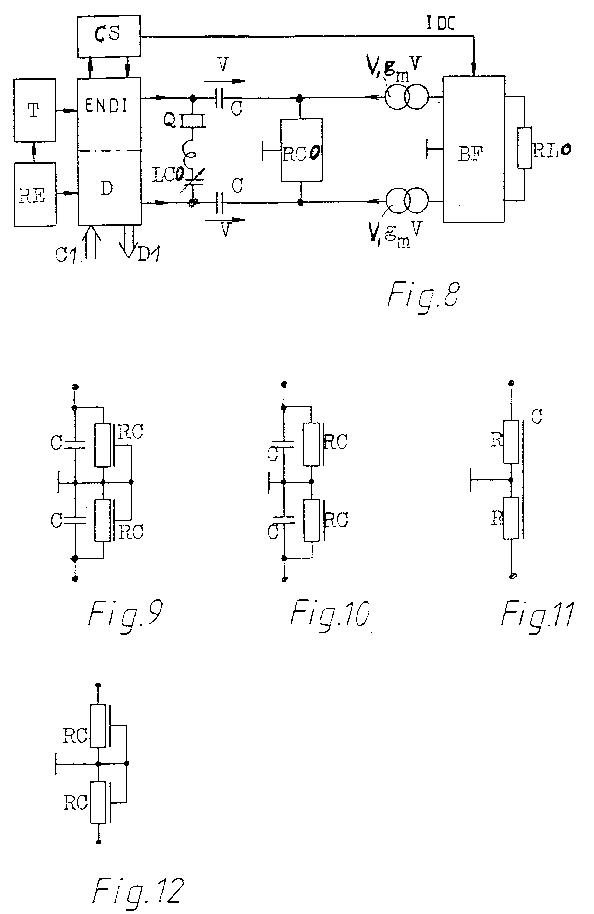

Wie Fig. 3 zeigt, sind im Inneren des Montageraums 203, 204 keine besonderen Abschirmungen zwischen den RF-verstärkenden Schaltungsteilen und den die Funktion überwachenden und steuernden Schaltungsteilen vorgesehen. Die Probleme der elektromagnetischen Interferenz konnten beseitigt werden durch die Kombination des dargestellten mechanischen Aufbaus mit geeigneten Verstärkerschaltungen, wie sie noch anhand der Fig. 8 und 13 erläutert werden.

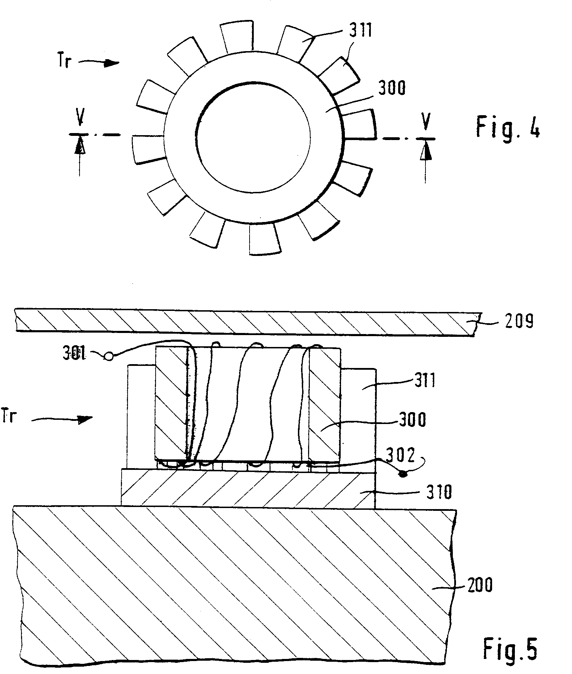

Bei einem kompakten Aufbau, wie er beim vorliegenden RF-Leistungsgenerator erreicht wurde, sind alle Bauelemente hoch belastet. Dies gilt auch für die magnetischen Bauelemente, beispielsweise den in Fig. 3 dargestellten Ringkern-Ausgangstransformator Tr. Fig. 4 zeigt eine Lösung, wie die in dem Ringkern 300 entstehende, unvermeidliche Verlustwärme optimal abgeführt werden kann. Der Ringkern 300 wird in einen topfförmigen Kühlkörper 310 eingesetzt, dessen Kühlfinger 311 sich außen an den Ringkern 300 anlegen. Zwischen den Kühlfingern 311 verbleibt genügend Platz für die Drahtwicklungen.

Fig. 5 Zeigt auszugsweise einen Längsschnitt durch das Modul der Fig. 3 im Bereich des Ringkerntransformators Tr. Man erkennt zwischen Kühlkörper 200 und Deckel 209 im tiefen Teil-Montageraum 204 den Ringkern 300, eingesetzt in den topfförmigen Kühlkörper 310 mit den Kühlfingern 311. Die Transformatorwicklungen 301, 302 sind schematisch eingezeichnet. Da der Kühltopf 310 den Kühlkörper 200 großflächig berührt, kann die im Ringkern 300 entstehende Verlustwärme auf dem kürzesten und schnellsten Weg nach außen abgeführt werden.

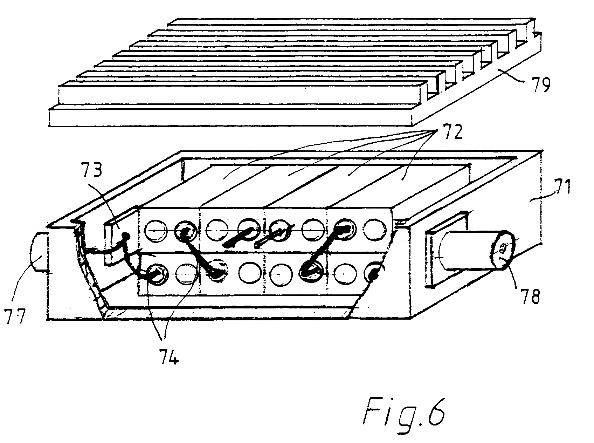

Fig. 6 zeigt in perspektivischer, teilweise aufgebrochener Darstellung einen Blick in das Innere des Tiefpaß-Hochleistungsfilters 70 mit einer RF-Leistungsdichte von ca. 3 kW/Liter. Es handelt sich um ein Chebishev-Filter 5. Ordnung. Die Spulen sind mit Doppelloch-Magnetkernen 72 realisiert. Diese haben großflächigen Kontakt zum Gehäuse 71 bzw. Deckel 79, so daß die unvermeidliche Verlustwärme optimal an die Umgebung abgeführt wird. Power-Chip-Kondensatoren 73 sind flach und direkt auf das als Masse wirkende Gehäuse 71 montiert. RF-Buchsen 77, 78 bilden den Eingang und Ausgang des Filters 70.

Durch die Größe der Abstände zwischen den Stirnseiten der Magnetkerne 72 und dem Gehäuse 71 läßt sich die magnetische Kopplung zwischen den Spulen verändern. Auf diese Weise ist es möglich, auch Filterkurven höherer Ordnung mit mehreren Polen und Nullstellen gezielt zu dimensionieren.

Ausschließlich dank der dargestellten Kompaktbauweise mit flachem Montageinnenraum konnte erreicht werden, daß auch bei RF-Leistungen von 1000 W und mehr keine parasitäre RF-Energie von der Eingangsbuchse 77 ungefiltert an die Ausgangsbuchse 78 gelangt. Die Amplitude der zweiten bzw. dritten Harmonischen liegt 50 bis 60 dB unter der Amplitude der Grundfrequenz. Höhere Harmonische sind nicht mehr meßbar. An der Ausgangsbuchse 78 erscheint also ein Sinussignal. Die Verluste im Durchlaß-Frequenzbereich des Filters liegen bei nur ca. 5 %, sind also überraschend klein.

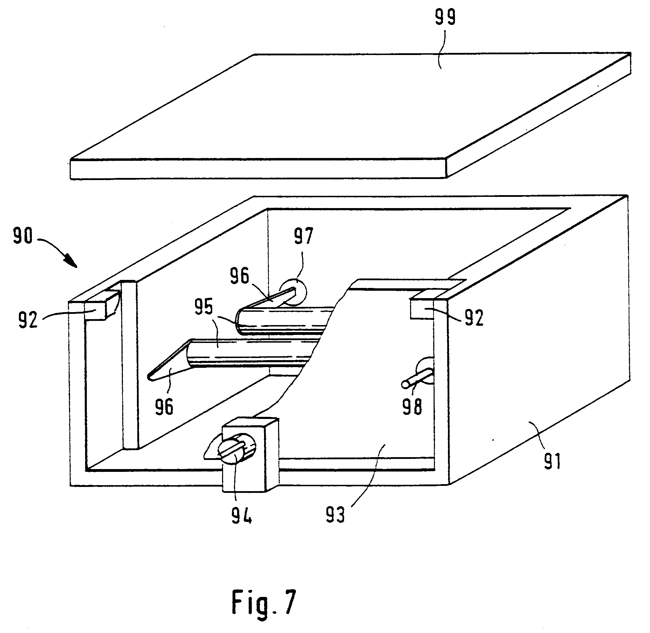

Fig. 7 zeigt in perspektivischer, teilweise aufgebrochener Darstellung den Richtkoppler 90. Man erkennt wieder ein flaches, parallelepipedisches Gehäuse 91, das mit einem Deckel 99 hochfrequenzdicht verschließbar ist. Die Vorderwand 93 ist jedoch lose. Sie wird oben von Halteklötzen 92 gehalten. Unten greift eine Justierschraube 94 an der Vorderwand 93 an. Dadurch kann die Position der Wand 93 fein justiert werden.

Im Inneren des Gehäuses 91 erkennt man zwei parallele, rohrförmige Leiterstücke 95. Diese sind mit Hilfe von blechförmigen, im rechten Winkel zu den Leiterstücken 95 ausgerichteten Zuleitungen 96 gehalten und mit Hilfe von Isolierstücken 97 in der Rückwand bzw. in der beweglichen Vorderwand gelagert. Außen sind Anschlüsse 98 vorgesehen.

Länge und Durchmesser der parallelen Leiterstücke 95 definieren den Koppelfaktor. Da es sich im vorliegenden Fall um einen Richtkoppler für Ausgangsleistungen von 1000 bis 5000 W handelt, kann der Koppelfaktor klein sein.

Form, Größe und Position der Leiterstücke 95 und der Zuleitungen 96 sind so gewählt, daß sich der gewünschte Wellenwiderstand von 50 Ohm ergibt. Dank der gefundenen Konstruktion bleiben Wellenwiderstand und Koppelfaktor unverändert, wenn die Justierschraube 94 verdreht wird.

Der gegenseitige Abstand der parallelen Leiterstücke 95 definiert das Richtverhältnis. Wird an der Justierschraube 94 gedreht, verändert die Wand 93 ihre Position und die beiden parallelen Leiterstücke 95 verändern ihren Abstand, bleiben jedoch parallel. Hierin unterscheidet sich der erfindungsgemäße Richtkoppler 90 von den handelsüblichen Richtkopplern, die zum Justieren des Richtverhältnisses wenigstens zwei Justierelemente benötigen.

Anhand der Fig. 8 soll die elektrische Schaltung des Sender-Moduls 10 erläutert werden. Man erkennt einen Kristall Q mit einer abstimmbaren LC-Schaltung LC0 in Serie. Die Anregung des Kristalls Q erfolgt über eine Push-Pull-MOS-Schaltung, geschaltet als spannungsgesteuerte Stromquellen V, $g_mV$, wobei $g_m$ die Transconductance ($g_m = \Delta I_{out}/\Delta V_{in}$) und V die Steuerspannung bezeichnet. Die Verwendung von MOS-Transistoren als Stromquelle ist aus den Application-Notes der einschlägigen Hersteller bekannt. Die für die Schwingungsanregung erforderliche positive Rückkopplung erfolgt mit Hilfe eines RC-Koppelgliedes RC0, welches anhand der Fig. 9 bis 12 noch näher erläutert wird.

Die beiden Stromquellen V, $g_mV$ arbeiten auf ein Ausgangs-Bandpaßfilter BF, das sekundärseitig mit einem Lastwiderstand RL0 abgeschlossen ist.

Wie schon erwähnt, ist auch das Sender-Modul 10 mit verschiedenen Überwachungs- und Steuerschaltungen ausgerüstet.

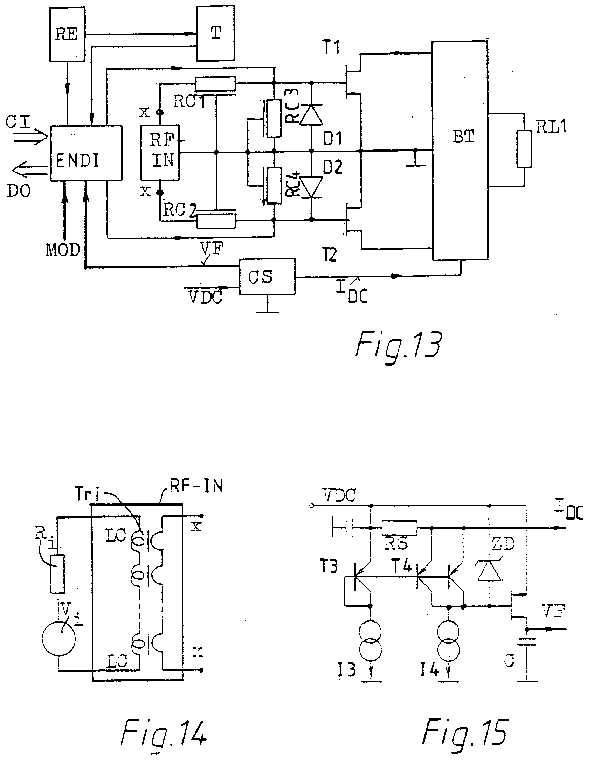

Als erstes wäre zu nennen eine Strom-Überwachungsschaltung CS, die anhand der Fig. 15 noch näher beschrieben wird. Übersteigt der Versorgungsgleichstrom IDC seinen Maximalwert, wird ein Überstrom-Sperrsignal an eine Enable-Disable-Einheit ENDI abgegeben.

Des weiteren wäre zu nennen eine Temperaturüberwachungsschaltung T. Hierbei handelt es sich im wesentlichen um einen Bipolar-Transistor als Fühler, der möglichst nahe an der thermisch am meisten belasteten Stelle der Schaltung, das sind üblicherweise die Transistoren, positioniert wird. Überschreitet die gemessene Temperatur einen vom Referenzelement RE vorgegebenen Wert, wird ein Übertemperatur-Sperrsignal an die Enable-Disable-Einheit ENDI abgegeben.

Schließlich ist noch eine Diagnoseeinheit D vorgesehen. Hier werden die eingehenden Steuersignale C1 ausgewertet, mit den von den Überwachungsschaltungen T, CS und der Referenz RE erzeugten Zustandssignalen verglichen und als Diagnose-Ausgangssignale D1 an die Logikeinheit 110 gemeldet.

Dank des Aufbaus der Sender-Schaltung als Push-Pull-MOS-Schaltung mit positiver Rückkopplung konnten eine hohe Leistungsdichte und eine hohe Frequenzstabilität erreicht werden. Die gemessenen Werte sind in Fig. 16 dargestellt. Man erkennt, daß bei einer Änderung der Umgebungstemperatur Tamb zwischen 0 und +40° C die Frequenz nur um ± 50 ppm variiert.

Die Fig. 9 bis 12 zeigen verschiedene Realisierungsmöglichkeiten für das RC-Glied RC0 in Fig. 7. Allen Schaltungsvarianten ist gemeinsam, daß sie unter Verwendung von verteilten RC-Gliedern RC realisiert sind.

Nur auf diese Weise war es möglich, die in herkömmlichen Schaltungen störenden Kapazitäten von Gehäuse und Kühlkörper nicht nur zu eliminieren, sondern sogar zur Erhöhung der Frequenzstabilität und zur Verkleinerung des Raumbedarfs auszunützen.

Anhand der Fig. 13 soll der Aufbau der Verstärkerschaltungen in den RF-Verstärkermodulen 30, 50 erläutert werden. Es handelt sich um eine Push-Pull-MOS-Verstärkerschaltung mit MOS-Transistoren T1, T2, die auf einen Breitbandtransformator BT arbeiten, der sekundärseitig mit einem Lastwiderstand RL1 abgeschlossen ist. Es versteht sich, daß die MOS-Transistoren T1, T2 bei höheren Leistungen durch eine Parallelschaltung mehrerer Einzeltransistoren ersetzt werden.

Das zu verstärkende RF-Signal wird einer RF-Eingangsschaltung RF-IN zugeführt. Diese wird anhand der Fig. 14 im einzelnen erläutert. Das an den Anschlüssen x - x anstehende Signal wird über Koppelnetzwerke RC1, RC2 bzw. RC3, RC4 mit verteilten Widerständen und Kondensatoren an die Steuerelektroden der MOS-Transistoren T1, T2 geleitet.

Vor den Steuerelektroden der MOS-Transistoren T1, T2 erkennt man Dioden D1, D2. Diese schneiden die negativen Halbwellen der RF-Signale ab. Dadurch wird zwar der Wirkungsgrad der Schaltung etwas gesenkt; gleichzeitig wird jedoch die obere Grenzfrequenz der Schaltung angehoben, was bei RF-Verstärkern von wesentlicher Bedeutung ist. Die Verstärkerschaltung selbst ist als Klasse-D-Schaltung ausgebildet und besitzt einen sehr hohen Wirkungsgrad.

Auch die Verstärkerschaltung nach Fig. 13 ist mit einer Temperaturüberwachungsschaltung T und einer Stromüberwachungsschaltung CS geschützt. Die Diagnoseeinheit D und die Enable-Disable-Einheit ENDI sind ebenfalls vorhanden.

Soll der Verstärkungsfaktor der RF-Verstärkerschaltung verändert werden, beispielsweise um das RF-Ausgangssignal zu modulieren, wird ein Modulationssignal MOD in die Enable-Disable-Einheit ENDI eingespeist. Durch logische Verknüpfung mit dem Disable-Signal, welches ein Teil der Steuereingangssignale CI ist, wird über die Leitungen DI das Potential an den Transistoren T1, T2 so beeinflußt, daß sich die gewünschte Veränderung des Verstärkungsfaktors einstellt.

Im übrigen wird das Potential an den Disable-Leitungen DI auch dazu benutzt, um beim Ansprechen der Temperatur-Überwachungsschaltung T oder der Überstrom-Überwachungsschaltung CS den Verstärkungsfaktor sehr schnell zu reduzieren, um eine Überlastung der Halbleiter zu verhindern.

Fig. 14 zeigt eine Realisierung der RF-Eingangsschaltung RF-IN aus Fig. 13. Die RF-Eingangsquelle Vi mit Innenwiderstand Ri speist einen Eingangstransformator Tri, dessen Primärwicklung als Leitung LC mit verteilten Induktivitäten L und Kapazitäten C ausgebildet ist. Die Sekundärwicklung besteht jeweils nur aus einer Windung, das gewünschte Übersetzungsverhältnis wird durch eine Hintereinanderschaltung von Sekundärwicklungen realisiert.

Fig. 15 zeigt die Schaltung der Strom-Überwachungsschaltung CS. Wesentliche Elemente dieser Schaltung sind Bipolar-Transistoren T3, T4, die von Konstantströmen I3, I4 durchflossen sind. Der Versorgungsgleichstrom IDC, z. B. aus der Versorgungsspannungsquelle VDC, fließt dabei über einen Strom-Meßwiderstand RS. Dadurch entsteht ein Spannungsabfall, der von den Transistoren T3, T4 gemessen und verstärkt wird und schließlich einen MOS-Schalttransistor T5 so steuert, daß an dessen Ausgang beim Überschreiten eines Schwellenwertes ein Überstromsignal VF auftritt, welches in der Enable-Disable-Einheit ENDI die beschriebenen Steuermaßnahmen auslöst.

Die Strom-Überwachungsschaltung CS funktioniert aufgrund der Tatsache, daß die Emitter-Flächen der Bipolar-Transistoren T3, T4 unterschiedlich sind. Der Strom IS durch den Meßwiderstand RS berechnet sich nach folgender Formel

$$IS = \frac{1}{RS} \cdot \frac{kT}{q} \ln \frac{I3}{I4} \cdot N$$

mit:

k = Boltzmann-Konstante,
q = elektrische Ladung eines Elektrons,
T = absolute Temperatur,
N = Verhältnis der Emitter-Flächen von T3 und T4.

Ein Vorteil der vorliegenden Schaltung ist ihre Schnelligkeit. Ein weiterer Vorteil ist ihre Temperaturunabhängigkeit; sie spricht nur an, wenn die Ströme IS bzw. IDC den für einen störungsfreien Betrieb der MOS-Schalttransistoren T1, T2 zulässigen Wert überschreiten.

Fig. 16 zeigt die relative Frequenzabweichung Delta f/fn des kompletten Generators 1 in Abhängigkeit von der Umgebungstemperatur Tamb bei maximaler Ausgangsleistung von 1 kW kontinuierlich an 50 Ohm Lastwiderstand. Es ist darauf hinzuweisen, daß der Kristall Q während der Messung nicht thermostatisiert war.

Fig. 17 zeigt den Wirkungsgrad eff (PRF/DC-Power-Input) der Schaltung nach Fig. 13 in Abhängigkeit von der Umgebungstemperatur Tamb bei Ausgangsleistungen PRF von 500, 750 und 1000 W. Der Wirkungsgrad liegt zwischen 80 und 87 %. Dieser Wert ist sehr hoch. Dank dessen ist die Verlustleistung mit 13 bis 20 % sehr klein. Dadurch erwärmen sich die Halbleiter, die Leiterplatten und die Kühlkörper nur wenig, so daß sich insgesamt ein sparsamer und störungsfreier Betrieb und vor allem die Möglichkeit eines sehr kompakten, platzsparenden Aufbaus ergibt.

Fig. 18 schließlich zeigt die RF-Ausgangsleistung PRF des kompletten Generator-Systems 1 in Abhängigkeit von der Umgebungstemperatur Tamb bei thermischem Gleichgewicht. Man erkennt, daß die Ausgangsleistung PRF auch bei der höchstzulässigen Umgebungstemperatur von 40 Grad C nur wenig absinkt. Die Messung erfolgte mit konstanter Versorgungsgleichspannung VDC, d. h. ohne den Vorwärts-Leistungs-Regler FPR in Fig. 2. Mit Vorwärts-Leistungs-Regler FPR läßt sich keine Temperaturabhängigkeit mehr messen.

Durch den kombinierten Einsatz von geeigneten RF-Schaltungen, insbesondere von Push-Pull-MOS-Schaltungen in allen Modulen, von optimierten Realisierungsprinzipien, insbesondere von Dünnschicht- bzw. Dickschicht-Hybrid-Schaltkreisen mit integrierten Widerständen und von SMD-Technik, sowie von optimierten Dimensionierungs- und Konstruktionsstrategien konnte ein RF-Generator-System geschaffen werden, das in einem Gehäuse mit einem Volumen von nur 4,6 Liter eine RF-Sinus-Ausgangsleistung von 0 bis 1000 W im Frequenzbereich zwischen 2 und 30 MHz erzeugt. Die RF-Leistungsdichte einschließlich Ventilator, Logikeinheit, Display, Metallgehäuse usw. liegt bei 220 W/Liter. Durch die Modul-Technologie und die Möglichkeit, jedes Modul durch externe Steuersignale zu beeinflussen, ist es möglich, sehr flexibel auf Kundenwünsche zu reagieren. Die eingebauten Strom- und Temperatur-Überwachungsschaltungen ermöglichen auch bei Höchstleistung einen störungsfreien, sicheren Betrieb. Die in jedes Modul eingebaute Diagnoseeinheit sowie die für alle Module gemeinsame Logikeinheit geben dem Benutzer jederzeit einen kompletten Überblick über den inneren Zustand des Generators, so daß Wartungs- und Reparaturarbeiten in jedem Fall rechtzeitig vor Auftreten eines eventuellen Defektes vorgenommen werden können.

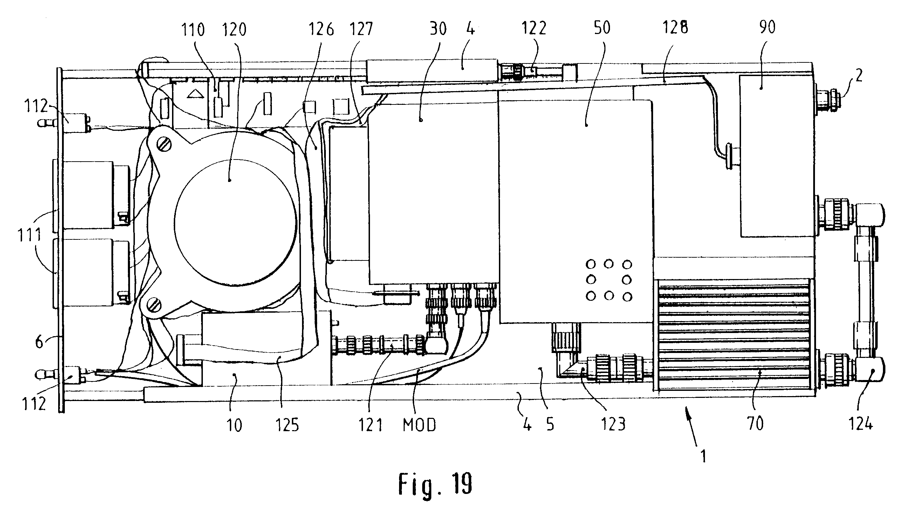

Fig. 19 schließlich zeigt eine Draufsicht auf das betriebsbereite RF-Leistungsgenerator-System mit 1000 W Sinus-Ausgangsleistung, aufgebaut aus Modulen 10, 30, 50, 70, 90 und eingebaut in ein flaches, quaderförmiges Gehäuse 1 mit einem Volumen von 4,6 Liter. Der Gehäusedeckel ist abgenommen, um den Blick in den Gehäuseinnere zu ermöglichen.

Das Gehäuse 1 besteht im wesentlichen aus zwei seitlichen Profilen 4, einem Frontblech und dem (nicht dargestellten) Gehäusedeckel. Das Leistungssendermodul 10 befindet sich in der Zeichnung unten rechts. Sein RF-Ausgangssignal wird über eine RF-Leitung 121 zu dem Zwischenverstärkermodul 30, von diesem über eine RF-Leitung 122 zum Leistungsendverstärkermodul 50, von diesem über eine RF-Leitung 123 zum Hochleistungsfilter 70 und von diesem über eine RF-Leitung 124 zum Hochleistungsrichtkoppler 90 geleitet. An dessen Ausgang 2 kann dann das Hochleistungs-Sinus-RF-Ausgangssignal PRF abgenommen werden. Zwischen der Logikeinheit 110, in der Zeichnung links unten dargestellt, und den Modulen 10, 30, 50, 90 sind Mehrfachkabel 126, 126, 127, 128 verlegt, über die die Diagnosesignale Di1, Di3, Di5 bzw. die Steuersignale Co1, Co3, Co5 sowie die Richtkoppler-Meßsignale übertragen werden.

Das Gehäuse 1 enthält zusätzlich einen leistungsfähigen Ventilator 120, der die Kühlluft zur Kühlung der Elektronikmodule 30, 50, des Hochleistungstiefpaßfilters 70 und des Hochleistungsrichtkopplers 90 erzeugt.

Wie Fig. 19 erkennen läßt, bietet das Innere des Gehäuses 1 trotz der hohen Leistungsdichte von 220 Watt pro Liter durchaus noch Freiräume, die den zusätzlichen Einbau leistungsstärkerer Komponenten ermöglichen.

**Patentansprüche**

1. RF-Leistungsgenerator-System, umfassend einen Sender (10) und wenigstens einen Leistungsverstärker (30, 50) als Elektronik-Einheiten, ein Ausgangsfilter (70), einen Richtkoppler (90), eine Logikeinheit (110), wobei alle Einheiten als Module aufgebaut und in ein Abschirmgehäuse (1) eingebaut sind, sowie gegebenenfalls eine ausreichend dimensionierte Kühlung (120), dadurch gekennzeichnet, daß die Elektronik-Einheiten (10, 30, 50) einen parallelepipedischen Kühlkörper (200) mit einem vertieften Montageraum (203), der mittels Deckel (204) RF-dicht verschließbar ist, aufweisen, daß in dem Montageraum (203) eine Schaltungsplatte (205), die elektronische Bauteile und Leiterbahnen trägt, sowie gegebenenfalls benötigte Drosseln (Dr) und/oder Transformatoren (Tr) mit optimalem Kontakt zu dem Kühlkörper (200) untergebracht sind, daß in jedes Elektronik-Modul (10, 30, 50) je eine schnell ansprechende Strom- und/oder Temperaturüberwachungsschaltung (CS, T), eine steuerbare Enable-Disable-Einheit (ENDI) und eine Diagnose-Einheit (D) integriert ist und daß die Logikeinheit (110) sowohl die Diagnose-Output-Signale (DO) der Module (10, 30, 50, 90) als auch externe Steuersignale logisch miteinander verknüpft und die Elektronik-Einheiten (10, 30, 50) mittels Input-Signalen (CI) steuert.

2. Generator-System nach Anspruch 1, dadurch gekennzeichnet, daß die Kühlkörper (200) Kühllamellen (201) besitzen und daß zwischen Abschirmgehäuse (1) und Kühllamellen (201) ein Luftkanal (202) für einen Kühlluftstrom (209) gebildet ist.

3. Generator-System nach Anspruch 2, dadurch gekennzeichnet, daß die Kühlkörper (200) von wenigstens zwei Leistungsmodulen (10, 30, 50) so hintereinander angeordnet sind, daß ein gemeinsamer Kühlkanal (209) entsteht.

4. Generator-System nach wenigstens einem der Ansprüche 1 bis 3, dadurch gekennzeichnet, daß Magnetkerne (300) im Montageraum (203) zwischen Kühlkörper (200) und Deckel (204) eingebaut sind.

5. Generator-System nach wenigstens einem der Ansprüche 1 bis 4, dadurch gekennzeichnet, daß magnetisch/thermisch hoch belastete Magnetkerne (300) in einen Kühltopf (310) mit anliegenden Kühlfingern (311) eingesetzt sind.

6. Generator-System nach wenigstens einem der Ansprüche 1 bis 5, dadurch gekennzeichnet, daß die Höhe des Montageraums (203 204) - bezogen auf die Schaltungsplatte (205), die Drosseln (Dr) und/oder die Transformatoren (Tr) - minimal und gegebenenfalls stufig angepaßt ist.

7. Generator-System nach wenigstens einem der Ansprüche 1 bis 6, dadurch gekennzeichnet, daß die Elektronik-Einheiten (10, 30, 50) als Dünnschicht- und/oder Dickschicht-Hybrid-Schaltungen auf gut wärmeleitenden Keramiksubstraten realisiert sind.

8. Generator-System nach wenigstens einem der Ansprüche 1 bis 7, dadurch gekennzeichnet, daß alle die RF erzeugenden bzw. verstärkenden Schaltungsteile als Push-Pull-Schaltung realisiert sind.

9. Generator-System nach wenigstens einem der Ansprüche 1 bis 8, dadurch gekennzeichnet, daß die Temperatur-Überwachungsschaltung (T) einen Halbleiter, insbesondere Bipolar-Transistor, als Temperatursensor verwendet und daß ihr Ausgang mit dem Disable-Signaleingang (Di) logisch verknüpft ist.

10. Generator-System nach wenigstens einem der Ansprüche 1 bis 9, dadurch gekennzeichnet, daß die Strom-Überwachungsschaltung (CS) wenigstens zwei Halbleiter, insbesondere zwei Bipolar-Transistoren (T3, T4), mit unterschiedlich großer Emitter-Fläche und einen vom DC-Speisestrom ($I_i$) durchflossenen Meßwiderstand (RS) aufweist und daß ihr Ausgang mit dem Disable-Signaleingang (Di) logisch verknüpft ist.

11. Generator-System nach wenigstens einem der Ansprüche 1 bis 10, dadurch gekennzeichnet, daß das erste Elektronik-Modul (10) ein kristallgesteuerter Sender ist mit einem Push-Pull-MOS-Verstärker mit positiver Rückkopplung zur Anregung des Quarzes (Q) und mit einer programmierbaren Ausgangsleistung von 1 - 10 Watt, vorzugsweise 3 Watt.

12. Generator-System nach wenigstens einem der Ansprüche 1 bis 11, dadurch gekennzeichnet, daß die MOS-Transistoren als spannungsgesteuerte Stromquellen (V, $g_m$ • V) geschaltet sind und daß als Rückkopplungsglied eine Zwei-Tor-Schaltung (RCφ) mit verteiltem RC-Netzwerk (RC) vorgesehen ist.

13. Generator-System nach wenigstens einem der Ansprüche 1 bis 12, dadurch gekennzeichnet, daß am Ausgang ein Bandpaß-Filter (BF) vorgesehen ist, das gleichzeitig als Balun-Transformator wirkt.

14. Generator-System nach wenigstens einem der Ansprüche 1 bis 13, dadurch gekennzeichnet, daß die Ausgangsspannung zwischen Sinus und Quasi-Rechteck programmiert umschaltbar ist.

15. Generator-System nach wenigstens einem der Ansprüche 1 bis 14, dadurch gekennzeichnet, daß die dem Sender-Modul (20) folgenden Module (30, 50) Push-Pull-MOS-Breitband-Verstärker sind.

16. Generator-System nach wenigstens einem der Ansprüche 1 bis 15, dadurch gekennzeichnet, daß die RF-Eingangsschaltung (RF-IN) als verteiltes LC-Netzwerk (LC) ausgebildet ist.

17. Generator-System nach wenigstens einem der Ansprüche 1 bis 16, dadurch gekennzeichnet, daß das zweite Elektronik-Modul (30) ein Zwischenverstärker ist mit einer programmierbaren Ausgangsleistung von 10 - 300 Watt, vorzugsweise 30 Watt.

18. Generator-System nach Anspruch 17, dadurch gekennzeichnet, daß ein Modulationseingang (30.6) für ein externes Rechteck-Modulationssignal (MOD) vorgesehen ist und daß das Modulationssignal (MOD) mit dem Enable/Disable-Signal (EN) gekoppelt ist.

19. Generator-System nach Anspruch 17, dadurch gekennzeichnet, daß im Eingangskreis (RF-IN) zwei Halbleiterdioden (D1, D2) vorgesehen sind, die vom Disable-Signal (DI) in den leitenden Zustand geschaltet werden und dann das RF-Steuersignal kurzschließen.

20. Generator-System nach wenigstens einem der Ansprüche 1 bis 19, dadurch gekennzeichnet, daß das dritte Elektronik-Modul (50) ein Hochleistungsverstärker mit einer programmierbaren Ausgangsleistung von bis zu 1000 Watt ist.

21. Generator-System nach wenigstens einem der Ansprüche 1 bis 20, dadurch gekennzeichnet, daß die letzte Elektronik-Einheit aus zwei parallelen Push-Pull-MOS-Breitband-Hochleistungsverstärkermodulen (50) zusammengesetzt ist, die im Push-Pull-Modus angesteuert werden.

22. Generator-System nach wenigstens einem der Ansprüche 1 bis 21, dadurch gekennzeichnet, daß der Leistungsverstärker (50) von einer externen DC-Versorgungsspannung (130) gespeist wird, deren Höhe veränderbar ist.

23. Generator-System nach nach wenigstens einem der Ansprüche 1 bis 22, dadurch gekennzeichnet, daß das vierte Modul (70) ein Tiefpaß-Filter hoher Ordnung und hoher Leistung auf minimalem Raum ist.

24. Generator-System nach Anspruch 23, dadurch gekennzeichnet, daß in einem gut wärmeleitenden Gehäuse (71) Spulen mit geschlossenen Magnetkernen (72) und Power-Chip-Kondensatoren (73) in Flachbauweise angeordnet sind, wobei die Magnetkerne (72) großflächigen Kontakt mit dem Gehäuse (71) haben.

25. Generator-System nach Anspruch 23, dadurch gekennzeichnet, daß der Tiefpaß als Chebishev-Filter 5. Ordnung ausgebildet ist, an dessen Ausgang die zweite bzw. dritte Harmonischen jeweils um mehr als 50 dB gegenüber der Grundfrequenz gedämpft sind.

26. Generator-System nach wenigstens einem der Ansprüche 1 bis 25, dadurch gekennzeichnet, daß das letzte Modul (90) ein Vierpol-Richtkoppler mit hoher Leistung, mit einem Richtverhältnis von wenigstens 40 dB und mit minimalem Raumbedarf ist.

27. Generator-System nach Anspruch 26, dadurch gekennzeichnet, daß in einem flach-parallelepipedischen Metallgehäuse (91) zwei rohrförmige Leitungsstücke (95) mit geringem Abstand parallel zueinander an Zuleitungen (96) montiert sind, daß die Zuleitungen (96) flache Blechstreifen sind, die im rechten Winkel von den Leitungsstücken (95) verlaufen und mittels Isolierstücken (97) durch zwei Wände des Gehäuses (91) hindurchgeführt sind, und daß eine dieser Wände (93) beweglich, insbesondere kippbeweglich ist.

28. Generator-System nach Anspruch 27, dadurch gekennzeichnet, daß am Gehäuse (91) eine Justierschraube (94) angebracht ist, die am Rande der beweglichen Wand (93) möglichst symmetrisch angreift.

29. Generator-System nach wenigstens einem der Ansprüche 1 bis 28, dadurch gekennzeichnet, daß die Überstrom-Signale (VF) am Ausgang wenigstens eines der Elektronik-Module (10, 30, 50) mit den Disable-Signaleingängen (10.3, 30.3, 50.3) der benachbarten Module (10, 30, 50) verkoppelt sind.

30. Generator-System nach Anspruch 29, dadurch gekennzeichnet, daß bei externer Modulation die Strom-Überwachungsschaltung (CS) in dem/den folgenden Verstärker-Modul/en (50) abgeschaltet ist.

31. Generator-System nach wenigstens einem der Ansprüche 1 bis 30, dadurch gekennzeichnet, daß eine Triggerstufe (2) vorgesehen ist, die als Rückwärtsleistungs-Komparator (RPC) geschaltet ist, deren einer Eingang (RPC+) mit dem Rückwärtsleistungs-Meßausgang (90.3) des Richtkopplers (90) und deren Ausgang mit dem Disable-Eingang (10.4) des RF-Sender-Moduls (10) gekoppelt ist, so daß beim Überschreiten einer eingestellten Triggerschwelle der RF-Sender (10) stoppt.

32. Generator-System nach wenigstens einem der Ansprüche 1 bis 31, dadurch gekennzeichnet, daß ein Vorwärts-Leistungs-Regler (FPR) in Form einer Spannungsvergleichsschaltung (131) vorgesehen ist, deren einer Eingang (131+) mit dem Vorwärtsleistungs-Meßausgang (90.1) des Richtkopplers (90) und deren Ausgang mit dem Steuereingang (130.1) eines regelbaren DC-Netzteils (130) gekoppelt ist, so daß die Höhe der DC-Versorgungsspannung (VDC) gesteuert und die RF-Leistung (PRF) am Ausgang (4) des Generators (1) geregelt wird.

Fig.1

Fig.2

EP 0 499 116 A1

Fig. 3

Tr →

311

300

V    V

Fig. 4

209

301

311

Tr →

300

302

310

200

Fig.5

Fig.6

Fig.7

Fig.8

Fig.9

Fig.10

Fig.11

Fig.12

Fig.13

Fig.14

Fig.15

Fig.16

Fig.17

Fig.18

Fig. 19

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | US-A-4 367 443 (HULL ET AL.)<br><br>* Spalte 2, Zeile 3 - Zeile 43 *<br>* Spalte 3, Zeile 24 - Spalte 6, Zeile 6 *<br>* Spalte 8, Zeile 11 - Zeile 29 *<br>* Abbildungen 1,5 *<br>--- | 1,9,11, 29 | H03F1/52<br>H03F3/24<br>H05K7/20 |
| A | US-A-4 001 711 (KNUTSON ET AL.)<br>* Spalte 1, Zeile 32 - Zeile 44 *<br>* Spalte 1, Zeile 56 - Spalte 2, Zeile 22 *<br>* Spalte 6, Zeile 29 - Zeile 63 *<br>* Abbildungen 1,3 *<br>--- | 1,7 | |
| A | 1978 IEEE MTT-S INTERNATIONAL MICROWAVE SYMPOSIUM DIGEST<br>1978, NEW YORK<br>Seiten 279 - 281;<br>W.E.SCHROEDER ET AL.: 'A 2W, 4 GHz GaAsFET Amplifier for Radio Relay Applications'<br>* Seite 279, Spalte 1, Zeile 23 - Spalte 2, Zeile 4; Abbildungen 1,2 *<br>--- | 1,2,3,6, 11,23 | |
| P,A | PATENT ABSTRACTS OF JAPAN<br>vol. 15, no. 209 (E-1072)28. Mai 1991<br>& JP-A-3 058 507 ( FUJITSU LTD ) 13. März 1991<br>* Zusammenfassung *<br>--- | 1,9 | |
| A | WO-A-9 009 703 (ALCATEL/BELL TELEPHONE)<br>* Seite 5, Zeile 17 - Zeile 24; Abbildung 1 *<br><br>----- | 10 | |

**RECHERCHIERTE SACHGEBIETE (Int. Cl.5)**

H03F
H05K

Der vorliegende Recherchenbericht wurde für alle Patentansprüche erstellt

| Recherchenort | Abschlußdatum der Recherche | Prüfer |
|---|---|---|
| DEN HAAG | 26 MAI 1992 | WALDORFF U. |